Europäisches Patentamt

European Patent Office

Office européen des brevets

(19)

(11) EP 0 810 442 A1

(12) EUROPÄISCHE PATENTANMELDUNG

(43) Veröffentlichungstag:
03.12.1997 Patentblatt 1997/49

(51) Int Cl.⁶: G01R 15/24

(21) Anmeldenummer: 97810260.6

(22) Anmeldetag: 25.04.1997

(84) Benannte Vertragsstaaten:
DE GB IT SE

(30) Priorität: 30.05.1996 DE 19621654

(71) Anmelder: ABB RESEARCH LTD.
8050 Zürich (CH)

(72) Erfinder:
• Baltensperger, Christian
  5610 Wohlen (CH)
• Bohnert, Klaus, Dr.
  5443 Niederrohrdorf (CH)
• Buser, Werner
  4052 Basel (CH)
• Ingold, Mathias, Dr.
  8103 Unterengstringen (CH)
• Zeindler, Frank
  8645 Jona (CH)

(74) Vertreter: Weibel, Beat et al
Asea Brown Boveri AG
Immaterialgüterrecht(TEI)
Haselstrasse 16/699 I
5401 Baden (CH)

(54) **Magneto-optischer Stromsensor**

(57)     Es wird ein magneto-optischer Stromsensor angegeben, bei dem mittels zweier Lichtquellen zwei gegenläufige Lichtstrahlen erzeugt werden, deren Intensität nach Durchlaufen eines einen Stromleiter umgebenden Sensorelements in zwei Detektionseinheiten gemessen wird. Dadurch, dass unmittelbar nach den Lichtquellen und vor den Detektionseinheiten Modenfilter eingeschaltet werden, erreicht man einer Verminderung der vibrationsbedingten nicht reziproken Störeinflüsse.

Fig.1

## Beschreibung

### Technisches Gebiet

Die Erfindung bezieht sich auf das Gebiet der Optoelektronik. Sie geht aus von einem magneto-optischen Stromsensor nach dem Oberbegriff des ersten Anspruchs.

### Stand der Technik

Ein solcher magneto-optischer Stromsensor wird beispielsweise in der Europäischen Patentanmeldung EP 0 657 740 A2 und dem Artikel "A Reciprocal-Compensated Fiber-Optic Current Sensor", IEEE, Journal of Lightwave Technology, Vol. 12, No. 10, Oct. 1994 von X. Fang et al. beschrieben. Der Stromsensor beruht auf dem Faraday-Effekt: Das Magnetfeld des Stromes bewirkt eine zum Strom proportionale Drehung der linearen Polarisationsrichtung des Lichtes. Demzufolge weisen solche Stromsensoren ein Sensorelement auf, das den stromführenden Leiter umschliesst. Ausserdem ist mindestens eine Lichtquelle, eine Multimode-Zuleitungsfaser und eine Detektionseinheit vorgesehen. In der Detektionseinheit wird die von der Polarisationsdrehung des Lichtes im Sensorelement abhängige Intensität nach Durchlaufen des Sensorelements detektiert. In den genannten Schriften wird vorgeschlagen, den Faraday-Stromsensor mit Hilfe von zwei gegenläufigen Lichtstrahlen vibrationsunempfindlich zu machen. Die beiden Lichtwellen durchlaufen dabei die gleichen Zuleitungsfasern und den gleichen Pfad im Sensorelement in gegenläufiger Richtung. Auf Grund des nicht reziproken Verhaltens des Faradayeffektes erscheinen die Messignale an den beiden Photodioden der beiden Detektionseinheiten in Phasenopposition, während die mechanisch bedingten Störsignale weitgehend in Phase auftreten. Die störenden Komponenten können dann durch elektronische Subtraktion der Photodiodensignale unterdrückt werden. Das eigentliche Messignal erscheint hingegen mit der doppelten Amplitude.

Beide eingangs genannten Schriften lassen jedoch die nicht reziproken Einflüsse z.B. der Übergangsstecker und des Sensorelements ausser Acht. Diese können jedoch eine erhebliche Störwirkung entfalten und die Messgenauigkeit empfindlich beeinträchtigen. Sie werden von der Elektronik auch nicht unterdrückt.

### Darstellung der Erfindung

Aufgabe der vorliegenden Erfindung ist es somit, einen magneto-optischen Stromsensor anzugeben, der eine grössere Unempfindlichkeit gegen nicht reziproke Störungen aufweist und eine höhere Messgenauigkeit erlaubt.

Diese Aufgabe wird bei einem magneto-optischen Stromsensor der eingangs genannten Art durch die Merkmale des ersten Anspruchs gelöst.

Der Kern der Erfindung besteht also darin, dass unmittelbar vor den Detektionseinheiten und allenfalls nach den Lichtquellen Modenfilter angeordnet sind.

Zusätzlich können die Modenfilter auch unmittelbar vor und nach dem Sensorelement angeordnet sein. Die Modenfilter bewirken, dass in den Pfaden, in denen das Licht dem Sensorelement zugeführt wird, die Moden höherer Ordnung, die von den mechanischen Schwingungen am meisten betroffen würden, gar nicht erst angeregt werden. Zudem bewirken die Modenfilter, dass höhere Moden, die durch die Vibrationen erzeugt bzw. moduliert wurden, vor Erreichen der Detektionseinheit herausgefiltert werden.

Zudem wurde erkannt, dass die Faserstecker besonders kritische Elemente bezüglich des Sensorverhaltens sind. Unpräzise Stecker mit einem seitlichen Versatz der Faserkerne und/oder einem Luftspalt zwischen den Faserenden verstärken die Störungen infolge von Faserbiegungen wesentlich. Dieser Einfluss ist um so gravierender, als der Effekt nicht reziprok ist. Er kann also durch die Elektronik nicht kompensiert werden. Eine präzise Ausrichtung der Faserkerne erlaubt demzufolge eine weitere Erhöhung der Messgenauigkeit. Ausserdem können durch einen Schräganschliff der Stecker Rückreflexe an den Faserstekkern vermieden werden. Die Rückreflexionen würden zum Messignal addiert und könnten zu einer Sättigung der Elektronik führen. Durch Vermeiden eines Luftspaltes zwischen den Faserenden in den Steckern können weitere nicht reziproke Einflüsse der Stecker vermindert werden.

Weitere Ausführungsbeispiele ergeben sich aus den entsprechenden abhängigen Ansprüchen.

Der Vorteil des erfindungsgemässen Aufbaus besteht darin, dass die nicht reziproken Störeinflüsse, die von den Übergangssteckern und dem Sensorelement hervorgerufen werden und die oft das Messignal übersteigen, wirksam unterdrückt werden können. Dies ergibt vor allem eine verminderte Empfindlichkeit gegenüber mechanischen Erschütterungen und damit eine erhöhte Messgenauigkeit.

### Kurze Beschreibung der Zeichnungen

Nachfolgend wird die Erfindung anhand von Ausführungsbeispielen im Zusammenhang mit den Zeichnungen näher erläutert.

Es zeigen:

Fig. 1    Eine schematische Darstellung des magneto-optischen Stromsensors nach der Erfindung;

Fig. 2    Eine Detailansicht eines im Rahmen der Erfindung verwendeten Modenfilters gemäss einem ersten Ausführungsbeispiel;

Fig. 3    Eine weitere Variante eines Modenfilters;

**Fig. 4** Eine dritte Variante eines Modenfilters;

**Fig. 5** Eine vierte Variante eines Modenfilters.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

**Wege zur Ausführung der Erfindung**

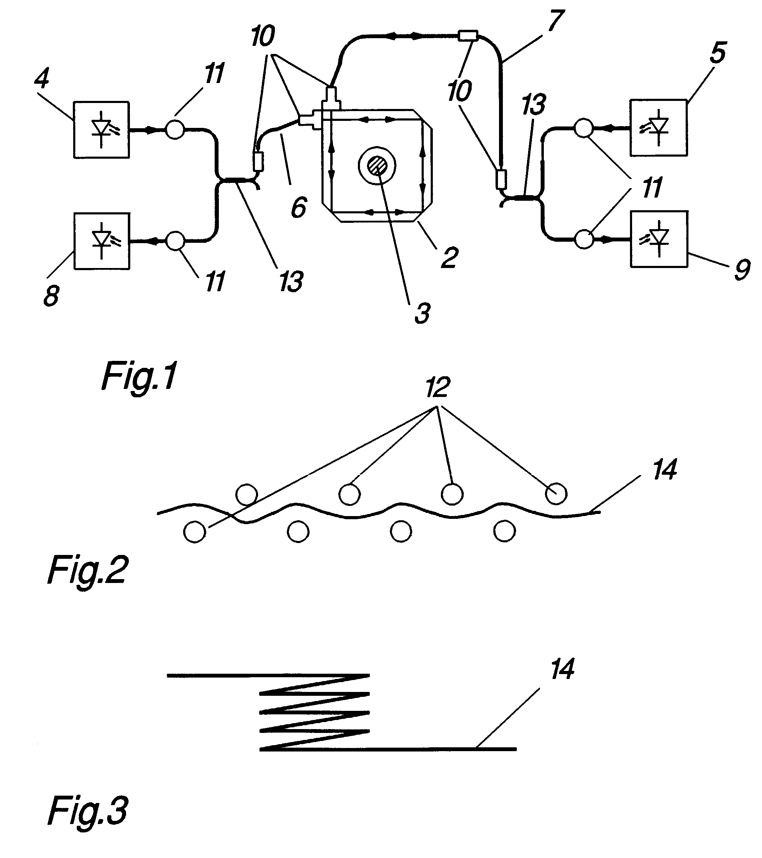

**Figur 1** zeigt schematisch einen magneto-optischen Stromsensor 1. Mit 2 ist ein Sensorelement bezeichnet, das einen Stromleiter 3 umschliesst. Das Sensorelement 2 wird von zwei gegenläufigen Lichtstrahlen durchlaufen. Diese werden in einer ersten Lichtquelle 4 und einer zweiten Lichtquelle 5 erzeugt und mittels einer ersten Zuleitungsfaser 6 und einer zweiten Zuleitungsfaser 7 zum Sensorelement 2 geführt. Nach Durchlaufen des Sensorelements 2 werden die Lichtstrahlen aus dem Sensorelement 2 ausgekoppelt und mittels der Zuleitungsfasern einer ersten bzw. zweiten Detektionseinheit 8 bzw. 9 zugeführt. Auf Grund des Faraday-Effekts wird die lineare Polarisation der Lichtstrahlen beim Durchlaufen des Sensorelements 2 proportional zu einem Magnetfeld, das durch den durch den Stromleiter 3 fliessenden Strom erzeugt wird, gedreht. Die prinzipielle Funktionsweise eines derartigen Stromsensors ist bekannt und kann beispielsweise den beiden eingangs genannten Schriften entnommen werden. In diesen Schriften wird insbesondere versucht, durch Vibrationen der Zuleitungsfasern und des Sensorelements hervorgerufene Störkomponenten durch die Verwendung zweier gegenläufiger Strahlengänge zu unterdrücken. Diese Einflüsse verhalten sich nämlich in erster Näherung reziprok, während der Faraday-Effekt nicht reziproker Natur ist.

Die Erfinder der vorliegenden Erfindung haben nun jedoch herausgefunden, dass auch die vibrationsinduzierten Intensitätsmodulationen der verwendeten Lichtstrahlen nicht reziproke Komponenten enthalten. Mögliche Störungen des magneto-optischen Stromsensors sind: Faserbiegung, Faservibration, Steckervibration oder Schock und Vibrationen des Sensorelements Diese Störungen verursachen in Verbindung mit der unterschiedlichen Modenfüllung an den Faserenden durch Abweichung der Faserpositionierung an den Faserübergängen, modenselektive Störungen durch Faserbiegung oder Vibration des Sensorelements in Kombination mit Modenfilterung in unpräzisen Fasersteckern nicht reziproke Komponenten.

Eine weitere unerwünschte Störungsquelle stellt auch das Sensorelement 2 selber dar. Dieses hat die Wirkung eines räumlichen Modenfilters und stellt damit für ungleiche Modenbelegung der gegenläufigen Lichtwellen eine Quelle für nicht reziproke Störsignale dar, die von der elektronischen Differenzbildung nicht eliminiert werden können.

Die erfinderische Leistung liegt nicht nur im Erkennen dieser nicht reziproken Einflüsse, sondern auch darin, dass Massnahmen angegeben werden, wie diese unerwünschten Einflüsse vermindert werden können.

Eine wirksame Verminderung dieser nicht reziproken Einflüsse erreicht man nach der Erfindung dadurch, dass unmittelbar vor den Detektionseinheiten 8, 9 und allenfalls unmittelbar nach den Lichtquellen 4 bzw. 5 und Modenfilter 11 eingeschaltet werden. Diese bewirken, dass in den Pfaden, in denen das Licht dem Sensorelement 2 zugeführt wird, die Moden höherer Ordnung, die von den mechanischen Schwingungen am meisten betroffen würden, gar nicht erst angeregt werden. Zudem bewirken die Modenfilter 11, dass höhere Moden, die durch die Vibrationen erzeugt bzw. moduliert werden, vor Erreichen der Detektionseinheiten 8, 9 herausgefiltert werden. Modenfilter 11 können auch direkt vor dem Sensorelement 2 oder nach diesem vorgesehen sein.

Ein derartiges Modenfilter 11 kann man beispielsweise dadurch erzeugen, dass ein Lichtwellenleiter 14 zu mehreren Windungen mit kleinem Biegeradius (z.B. 10-25 Windungen mit einem Radius von 12.5 mm) aufgewickelt wird (**Figur 3**). Eine weitere Möglichkeit bietet das Einflechten des Lichtwellenleiters 14 durch eine Reihe von Stäben 12 (**Figur 2**). Durch die kleinen Biegeradien werden die höheren Moden aus der Faser ausgekoppelt. Nachteilig an diesen Lösungen ist jedoch, dass der Lichtwellenleiter 14 mechanisch stark belastet wird.

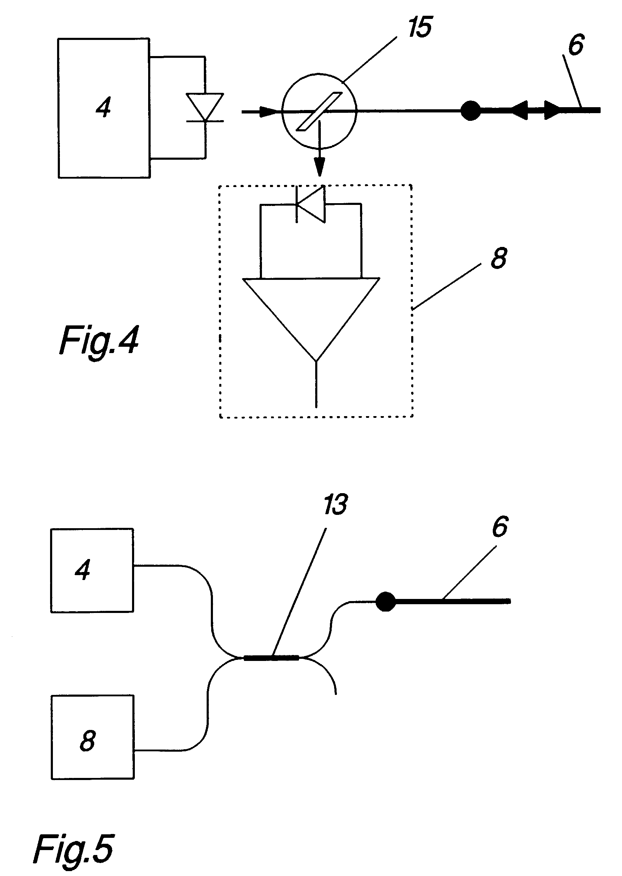

Eine elegantere und sehr effiziente Möglichkeit bieten die faseroptischen Koppler 13, die zur Aus- bzw. Einkopplung der gegenläufigen Lichtstrahlen in die Zuleitungsfasern 6, 7 vorgesehen sein müssen. Sie wirken als Strahlteiler (**Figur 5**). Eine sehr effiziente Ausfilterung der höheren Moden in einem solchen Koppler erreicht man dadurch, dass die numerische Apertur des Kopplers kleiner ist diejenige der Verbindungsfasern gewählt wird. Bewährt haben sich Fasern mit einer numerischen Apertur von 0.37 und Koppler mit einer Apertur von lediglich 0.26.

Falls keine faseroptischen Strahlteiler verwendet werden, sondern konventionelle Strahlteilerwürfel 15 (**Figur 4**), so kann die Modenfilterung auch durch kurze Faserstücke mit reduzierter numerischer Apertur erzielt werden. Diese kurzen Faserstücke werden dann dem Strahlteiler z.B. nachgeschaltet.

Diese Variante mit den als Modenfilter wirkenden Koppler 13 oder dem Strahlteiler 15 stellt einen sehr einfachen Aufbau dar, bei dem die vor den Detektionseinheiten 8, 9 bzw. vor den Lichtquellen 4, 5 angeordneten Modenfilter 11 zusammengefasst werden können.

Besonders kritische Elemente sind auch die Faserstecker, die als Übergangsstecker sowohl zwischen den Kopplern 13 und den Zuleitungsfasern 6, 7 als auch zwischen den Zuleitungsfasern und dem Sensorelement 2 vorgesehen sein können. Unpräzise Stecker mit einer lateralen Versatz der Faserkerne und/oder einem Luftspalt zwischen den Faserenden verstärken die Störungen infolge von Faserbiegungen wesentlich. Faserbiegungen oder -vibrationen ändern die relativen Amplituden der Moden bzw. koppeln höhere Moden aus der Faser aus. An unpräzisen Steckern ändert sich die Lichtintensität, die von einer Faser in die andere Faser übergekoppelt wird, mit der Modenverteilung. Das heisst, die transmittierte Lichtintensität erfährt am Stecker infolge seiner Wirkung als räumliches Filter eine zusätzliche Modulation, die sogar weit grösser sein kann, als die Modulation, die unmittelbar mit der Faserbiegung zusammenhängt. Dieser Effekt ist nicht reziprok: Die Lichtwelle, die die Störung sieht, bevor sie den Stecker erreicht, wird am Stecker stark moduliert, während die gegenläufige Lichtwelle, die dieselbe Störung erst nach Durchlaufen des Steckers erfährt, deutlich weniger stark moduliert wird. Eine Kompensation dieser Störungen durch die Differenzbildung nach dem Stand der Technik ist daher nicht möglich.

Deshalb sollten die Faserenden in den Steckern eine maximale Abweichung der Faserkerne von +/- 10% des Kerndurchmessers aufweisen. Ausserdem ist es von grossem Vorteil, wenn sich zwischen den Faserenden kein Luftspalt befindet.

Eine weitere Störung, die in den Steckern 10 hervorgerufen wird und durch die elektronische Differenzbildung nur beschränkt behoben werden kann, stellt das starke optische Übersprechen zwischen den Kanälen als Folge von Lichtreflexionen an den freien Faserenden innerhalb der Stecker dar. Um diese störenden Einwirkungen an den Übergangssteckern 10 zu vermindern, wird nach der Erfindung vorgeschlagen, die Stecker mit einem Schräganschliff der Faserenden im Bereich von 10°-18°, noch besser von 14°-16° zu versehen. Die besten Resultate wurden mit einem Schräganschliff von ungefähr 15° erreicht. Zusammen mit einer präzisen Ausrichtung der Faserkerne ohne Luftspalt konnte ein drastische Verbesserung des Messverhaltens erreicht werden.

Das Sensorelement ist als massiver Glaskörper, in den die Lichtstrahlen kollimiert eingekoppelt werden (wie in Figur 1 dargestellt) ausgeführt. Lineare Doppelbrechung im Glasblock stellt eine weitere Ursache nicht reziproker Lichtmodulation dar. Nicht reziprokes Verhalten der Doppelbrechung entsteht vor allem durch:

- unterschiedliche Wellenlängen $\lambda_1$, $\lambda_2$ der gegenläufigen Lichtstrahlen
- räumlich getrennte Lichtstrahlen im Sensorkopf;
- inhomogene Doppelbrechungsverteilung.

Dabei sind dynamische und statische Doppelbrechung zu unterscheiden. Dynamische Doppelbrechung wird durch auf das Sensorelement wirkende Vibrationen und mechanische Schocks hervorgerufen. Die resultierende Intensitätsmodulation ist ungefähr proportional zur Wellenlänge im Quadrat. Zur Gewährleistung hinreichender Reziprozität dürfen $\lambda_1$ und $\lambda_2$ höchstens um 20% differieren, d.h.

$$\frac{\lambda_1 - \lambda_2}{\frac{1}{2}(\lambda_1 - \lambda_2)} \leq 20\%$$

Insgesamt ergibt sich mit den erfindungsgemässen Massnahmen ein magneto-optischer Stromsensor, bei dem die nicht reziproken Störungen einen weit geringeren Einfluss ausüben, wodurch die Messgenauigkeit des Sensors erheblich verbessert werden kann.

**Bezugszeichenliste**

1 Magneto-optischer Stromsensor
2 Sensorelement
3 Stromleiter
4 erste Lichtquelle
5 zweite Lichtquelle
6 erste Zuleitungsfaser
7 zweite Zuleitungsfaser
8 erste Detektionseinheit
9 zweite Detektionseinheit
10 Übergangsstecker
11 Modenfilter
12 Stab
13 faseroptischer Koppler
14 Lichtwellenleiter
15 Strahlteiler

**Patentansprüche**

1. Magneto-optischer Stromsensor (1) umfassend

- ein Sensorelement (2), das einen Stromleiter (3) umschliesst;
- mindestens eine erste und eine zweite Lichtquelle (4, 5), die einen ersten bzw. zweiten Lichtstrahl erzeugen, die das Sensorelement (2) gegenläufig durchlaufen und die über eine erste und eine zweite lichtleitende Zuleitungsfaser (6, 7) in das Sensorelement (2) eingekoppelt werden;
- mindestens eine erste und zweite Detektionseinheit (8, 9), die eine von einer Polarisationsdrehung im Sensorelement abhängige Intensität des ersten bzw. zweiten Lichtstrahls nach Durchlaufen des Sensorelements (2) erfassen;

dadurch gekennzeichnet, dass

- Modenfilter (11) vorgesehen sind, die unmittelbar vor den Detektionseinheiten (8, 9) und allenfalls nach den Lichtquellen (4, 5) angeordnet sind.

**2.** Magneto-optischer Stromsensor nach Anspruch 1, dadurch gekennzeichnet, dass eine Mehrzahl von Übergangssteckern (10) zur Ein- oder Auskoppelung der Lichtstrahlen von den Lichtquellen (4, 5) in die Zuleitungsfasern (6, 7) bzw. aus den Zuleitungsfasern (6, 7) in die Detektionseinheiten (8, 9) und/ oder von den Zuleitungsfasern (6, 7) in das Sensorelement (2) bzw. aus dem Sensorelement (2) in die Zuleitungsfasern (6, 7) und/oder zwischen Abschnitten der Zuleitungsfasern vorgesehen sind.

**3.** Magneto-optischer Stromsensor nach Anspruch 2, dadurch gekennzeichnet, dass die Faserenden in den Übergangsstecker (10) mit einem Schräganschliff im Bereich von 10° bis 18° versehen sind.

**4.** Magneto-optischer Stromsensor nach Anspruch 3, dadurch gekennzeichnet, dass der Schräganschliff im Bereich von 14°-16° liegt und insbesondere 15° beträgt.

**5.** Stromsensor nach einem der Ansprüche 1 bis 4, dadurch gekennzeichnet, dass die Übergangsstecker (10) keinen Luftspalt zwischen den Faserenden und/oder die Faserkerne in den Übergangssteckern einen lateralen Versatz von kleiner gleich +/- 10% des Faserdurchmessers aufweisen.

**6.** Stromsensor nach Anspruch 1, dadurch gekennzeichnet, dass die Modenfilter (11) mehrere Windungen der Zuleitungsfasern (6, 7) mit kleinem Biegeradius umfassen.

**7.** Stromsensor nach Anspruch 1, dadurch gekennzeichnet, dass die Modenfilter (11) einen Abschnitt der Zuleitungsfasern (6, 7) umfassen, in welchem die Zuleitungsfasern (6, 7) zwischen einer Mehrzahl von Stäben (12) hindurch geflochten sind.

**8.** Stromsensor nach Anspruch 1, dadurch gekennzeichnet, dass als Modenfilter (11) faseroptische Koppler (13) vorgesehen sind, die die gegenläufigen Lichtstrahlen vor den Lichtquellen (4, 5) bzw. Detektionseinheiten (8, 9) aufteilen und deren numerische Apertur kleiner ist als diejenige der Zuleitungsfasern (6, 7).

**9.** Stromsensor nach einem der vorstehenden Ansprüche, dadurch gekennzeichnet, dass das Sensorelement (2) einen Glaskörper umfasst, der den Stromleiter (3) umschliesst.

**10.** Stromsensor nach Anspruch 9, dadurch gekennzeichnet, dass der Glaskörper vor Einbau in den Stromsensor getempert wurde.

**11.** Stromsensor nach einem der vorstehenden Ansprüche, dadurch gekennzeichnet, dass sich die Wellenlängen der beiden gegenläufigen Lichtstrahlen um weniger als 20% unterscheiden.

**12.** Stromsensor nach einem der vorstehenden Ansprüche, dadurch gekennzeichnet, dass zusätzliche Modenfilter 11 in beide Zuleitungsfasern (6,7) vor dem Sensorelement (2) eingeschaltet sind.

**Fig.1**

**Fig.2**

**Fig.3**

Fig.4

Fig.5

Europäisches
Patentamt

**EUROPÄISCHER RECHERCHENBERICHT**

Nummer der Anmeldung

EP 97 81 0260

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| Y,D | EP 0 657 740 A (ABB RESEARCH)<br>* Spalte 2, Zeile 47 - Spalte 9, Zeile 54; Anspruch 3; Abbildungen 1,5,6 *<br>--- | 1,6,9,11 | G01R15/24 |
| Y | MEASUREMENT SCIENCE AND TECHNOLOGY,<br>Bd. 7, Nr. 5, 1.Mai 1996,<br>Seiten 796-800, XP000597119<br>FISHER N E ET AL: "A COMMON-MODE OPTICAL NOISE-REJECTION SCHEME FOR AN EXTRINSIC FARADAY CURRENT SENSOR"<br>* Seite 797, linke Spalte, Absatz 5 - rechte Spalte, Absatz 1 *<br>* Seite 797, rechte Spalte, Absatz 4 - Absatz 5; Abbildung 2 *<br>--- | 1,6,9,11 | |
| A | WO 93 15410 A (INSTRUMENT TRANSFORMERS)<br>* Seite 7, Absatz 3 - Absatz 4; Abbildung 5 *<br>----- | 1 | |
| | | | **RECHERCHIERTE SACHGEBIETE (Int.Cl.6)**<br><br>G01R |

Der vorliegende Recherchenbericht wurde für alle Patentansprüche erstellt

| Recherchenort | Abschlußdatum der Recherche | Prüfer |
|---|---|---|
| DEN HAAG | 26.Juni 1997 | Iwansson, K |